# EUROPEAN PATENT APPLICATION

(11) **EP 4 598 308 A1**
(43) Date of publication of application: **06.08.2025**
(21) Application number: 24858484.9
(22) Date of filing: 23.08.2024
(51) Int. Cl.: H10F 19/90

(54) **SOLAR CELL STRING AND SOLAR CELL MODULE**

(30) Priority: 31.08.2023 CN 202322368917 U; 05.07.2024 CN 202421593306 U
(71) Applicant: Huansheng New Energy (Jiangsu) Co., Ltd., Yixing Wuxi, Jiangsu 214203 (CN)
(72) Inventor: MU, Chengwei, Wuxi, Jiangsu 214203 (CN); YANG, Qing, Wuxi, Jiangsu 214203 (CN); WANG, Peng, Wuxi, Jiangsu 214203 (CN); CHEN, Liangshui, Wuxi, Jiangsu 214203 (CN); WANG, Yan, Wuxi, Jiangsu 214203 (CN)
(74) Representative: Cicconetti, Andrea
(86) International application number: PCT/CN2024/114343
(87) International publication number: WO 2025/044948

(57) **Abstract**

The present invention provides a solar cell string and a photovoltaic cell module, relating to the technical field of photovoltaic module manufacturing. The busbar ribbon of the solar cell string in the embodiment of the present invention includes a plurality of soldering parts and non-soldering parts connecting two adjacent soldering parts. The soldering parts are welded to at least one interconnector, ensuring the melting and contact soldering effect of the tin layer. The non-soldering parts are arranged with spacing from at least one interconnector, which can release the stress generated by thermal expansion and contraction between the busbar ribbon and the interconnector during the soldering process of the busbar ribbon, preventing pulling and misalignment of the soldering tape on the rear surface of the solar cell caused by shrinkage after soldering of the busbar ribbon. Alternatively, the busbar ribbon of the solar cell string in the embodiment of the present invention includes a plurality of fixed points arranged at intervals along the length direction and non-fixed sections connecting two adjacent fixed points. The fixed points are fixedly connected to the interconnectors thereunder, and the non-fixed sections are in contact with at least a partial number of the interconnectors thereunder. This can reduce the material consumption of a single solar cell and avoid the occurrence of pulling and misalignment.

## Description

### CROSS-REFERENCE TO RELATED APPLICATION

The present invention claims priority to Chinese patent application No. 202322368917.4 filed with the Chinese Patent Office on August 31, 2023, entitled "SOLAR CELL STRING AND PHOTOVOLTAIC CELL MODULE" and Chinese patent application No. 202421593306.8 filed with the Chinese Patent Office on July 5, 2024, entitled "SOLAR CELL STRING AND PHOTOVOLTAIC CELL MODULE", the entire contents of which are incorporated by reference in the present invention.

### TECHNICAL FIELD

The present invention relates to the technical field of photovoltaic module manufacturing, and more specifically, to a solar cell string and a photovoltaic cell module.

### BACKGROUND ART

Currently, conventional shingled photovoltaic cell modules are designed entirely in parallel. The current of a single string of cell strings is low, approximately 1/5 to 1/6 of that of a full-size solar cell. Three bypass diodes are used in parallel within the circuit, and the electrical design of the bypass diodes is achieved by soldering the busbar ribbon corresponding to the bypass diode to the solder pad on the rear surface of the solar cell. However, traditional half-cell modules adopt a series-parallel design for the cell strings, with three bypass diodes connected in parallel in the circuit. The electrical design of the bypass diodes is achieved by directly soldering the busbar ribbon corresponding to the bypass diode to the interconnector. The interconnectors are designed to extend 5~10mm beyond the solar cell and overlap with the busbar ribbon by 50%~100%.

However, the method of soldering the busbar ribbon to the solder pad on the rear surface of the solar cell has the following issues. 1. The process window is narrow. To ensure soldering quality, soldering materials such as solder paste or flux need to be added, which will increase the material consumption. 2. The PAD on the rear surface of the solar cell uses silver paste. To ensure soldering quality, the silver paste consumption for a single solar cell increases by 10~20mg, which also reduces the solar cell efficiency. 3. It increases the recombination of the rear surface, which lowers the solar cell efficiency by 0.03%~0.08%. 4. Since the busbar ribbon is directly welded to the solar cell, the trend toward thinner solar cell increases the likelihood of micro cracks of the solar cell by 0.02%~0.05%. In traditional half-cell modules, the bypass diode design in the middle achieves the connection by directly soldering the busbar ribbon corresponding to the bypass diode to the interconnector. The interconnectors are designed to extend 5~10mm beyond the solar cell and overlap with the busbar ribbon by 50%~100%. A soldering region of 10mm~20mm is reserved in the middle of the module for soldering the busbar ribbon and interconnector. However, since the busbar ribbon in the middle is welded to the interconnectors on both sides, the cell strings at the head and tail of the module must be misplaced by approximately 0.5mm. The soldering of the interconnectors on both sides interferes with each other, reducing module efficiency by 0.1%~0.2%.

Additionally, during the lamination process of photovoltaic modules, the encapsulant flows, causing slight displacement of the cell strings. This results in pulling and twisting between the interconnectors at the head and tail of the cell strings and the busbar ribbon, thereby reducing the aesthetic appearance of the module.

### SUMMARY

The objective of the embodiments of the present invention is to provide a solar cell string and a photovoltaic cell module. The busbar ribbon is directly welded to the interconnector through soldering parts, thus ensuring the melting and contact soldering effect of the tin layer. The non-soldering parts are arranged with spacing from at least one interconnector, which can release the stress generated by thermal expansion and contraction between the busbar ribbon and the interconnector during the soldering process of the busbar ribbon, preventing pulling and misalignment of the soldering tape on the rear surface of the solar cell caused by shrinkage after soldering of the busbar ribbon, and improving the overall aesthetic appearance of the module. It addresses defects of the above-mentioned cost, efficiency, and process associated with directly soldering the busbar ribbon corresponding to the bypass diode to the solder pad on the rear surface of the solar cell in current shingled photovoltaic cell modules, and also addresses the technical issues such as defects in the soldering effect, module efficiency, and post-lamination appearance, which is caused by the 10~20mm soldering region formed by the connection between the busbar ribbon and interconnector in the half-cell modules.

Another objective of the embodiments of the present invention is to provide another solar cell string and photovoltaic cell module, which eliminates the need for the arrangement of solder pads on the surface and additional auxiliary soldering materials, thereby reducing the material consumption of a single solar cell and improving the solar cell efficiency. The fixed points of the busbar ribbon are fixedly connected to the interconnector, ensuring a good connection performance of the busbar ribbon and reducing the occurrence of defects. The non-fixed sections of the busbar ribbon are in contact with but not fixed to the interconnector, thus reducing pulling and twisting caused by the slight displacement of the cell string and improving the overall aesthetic appearance of the module.

In a first aspect, the embodiments of the present invention provide a solar cell string, including busbar ribbons, interconnectors, and solar cells.

A plurality of solar cells are arranged sequentially along a preset direction, and adjacent solar cells are connected through the interconnector.

The busbar ribbon is provided on the solar cells and extends along an arrangement direction of the solar cells.

Along the extension direction of the busbar ribbon, the busbar ribbon comprises a plurality of soldering parts and non-soldering parts connecting two adjacent soldering parts, wherein the soldering parts are welded with at least one interconnector, and the non-soldering parts are arranged with spacing from at least one interconnector.

As a further technical solution, the non-soldering parts are arched relative to two adjacent soldering parts.

As a further technical solution, an arched shape of the non-soldering parts is arc-shaped, triangular, trapezoidal, or rectangular.

As a further technical solution, a joint between the soldering parts and the non-soldering parts is arranged as chamfered, right-angled, or rounded.

As a further technical solution, an arching height of the non-soldering parts is h, and 0 < h ≤ 2mm.

As a further technical solution, the solar cells have a front surface and a rear surface, and the busbar ribbon is located on the rear surface of the solar cells and welded with the rear surface of the interconnector.

As a further technical solution, a thickness of the busbar ribbon is 0.05mm-0.15mm.

As a further technical solution, a width of the busbar ribbon is 5mm-15mm.

As a further technical solution, the solar cells are formed by dividing a 182mm silicon wafer into two or three slices; or
the solar cells are formed by dividing a 210mm silicon wafer into two or three slices.

In a second aspect, the embodiments of the present invention provide a photovoltaic cell module, including three bypass diodes; and six solar cell strings arrayed parallelly.

The six solar cell strings comprise three solar cell strings on a left side connected in parallel to form a first group, and three solar cell strings on a right side connected in parallel to form a second group, and the first group and the second group are connected in series.

The three bypass diodes are connected in parallel through the busbar ribbon.

Compared with the prior art, the solar cell string and photovoltaic cell module provided by the present invention have the following technical advantages.

The solar cell string provided by the present invention includes busbar ribbons, interconnectors, and solar cells. A plurality of solar cells are arranged sequentially along a preset direction, and adjacent solar cells are connected through the interconnector. The busbar ribbon is provided on the solar cells and extends along an arrangement direction of the solar cells. Along the extension direction of the busbar ribbon, the busbar ribbon comprises a plurality of soldering parts and non-soldering parts connecting two adjacent soldering parts, wherein the soldering parts are welded with at least one interconnector, and the non-soldering parts are arranged with spacing from at least one interconnector.

The busbar ribbon is arranged on the solar cell and directly welded to the interconnector through soldering parts, thus ensuring the melting and contact soldering effect of the tin layer. The non-soldering parts are arranged with spacing from at least one interconnector, which can release the stress generated by thermal expansion and contraction between the busbar ribbon and the interconnector during the soldering process of the busbar ribbon, preventing pulling and misalignment of the soldering tape on the rear surface of the solar cell caused by shrinkage after soldering of the busbar ribbon. Compared to the direct contact soldering of the busbar ribbon and the solder pad on the rear surface of the solar cell in the prior traditional shingled photovoltaic cell modules, this arrangement has a lower fragmentation rate, a larger process window, and does not require auxiliary soldering materials such as solder paste or flux. Additionally, the amount of back silver is significantly reduced, thus improving the solar cell efficiency. Even for thinner solar cells, the risk of micro cracks in the solar cell is lower. Compared to the soldering method of the prior half-cell modules, this arrangement eliminates the need for a 10mm~20mm soldering region between the busbar ribbon and the interconnector in the middle of the module. During soldering, the head and tail cell strings of the module do not need to be misaligned, and the soldering of interconnectors on both sides does not interfere with each other, thereby improving module efficiency. Furthermore, it releases the pulling force exerted on the cell strings by encapsulant flow during the lamination process, thus reducing the risk of micro cracks and fragmentation in the cell strings, and enhancing the overall aesthetic appearance.

The photovoltaic cell module provided in the present invention includes the aforementioned solar cell string. Accordingly, the technical advantages and effects achieved by the solar module include the technical advantages and effects achieved by the aforementioned solar cell string, which are not elaborated herein.

In a third aspect, the embodiments of the present invention provide a solar cell string, including at least two solar cells arranged sequentially, wherein two adjacent solar cells are respectively connected through a plurality of interconnectors, and one busbar ribbon is provided on all the interconnectors connected to at least one solar cell.

The busbar ribbon comprises a plurality of fixed points arranged at intervals along a length direction and non-fixed sections connecting two adjacent fixed points, wherein the fixed points are fixedly connected to the interconnectors thereunder; at least some of the non-fixed sections are laid on the interconnectors; the non-fixed sections are not fixedly connected to the interconnectors thereunder; and the non-fixed sections are in contact with at least some of the interconnectors thereunder.

In the above implementation process, the solar cell is connected to the busbar ribbon through the interconnector, which eliminates the need for arranging solder pads on the surface of the solar cell and for adding auxiliary soldering materials such as solder paste or flux. Therefore, the process window is larger, the material consumption of individual solar cells also is reduced, and the solar cell efficiency is improved. The fixed points of the busbar ribbon are fixedly connected to the corresponding interconnectors, and the non-fixed sections of the busbar ribbon are in contact with the corresponding interconnectors. This not only increases the contact points of the busbar ribbon, ensuring a good connection performance and solving the heating issues, but also provides a relatively flat whole structure with less stress on the solar cell, thereby reducing the occurrence of defects. Even with thinner solar cells, the overall fragmentation rate during lamination remains lower. Furthermore, the arrangement and connection method of the interconnectors and busbar ribbon as described above can release the pulling force exerted on the cell string by encapsulant flow during the lamination process, avoid the pulling and twisting phenomena between the interconnectors and the busbar ribbon, and enhance the overall aesthetic appearance of the module.

In one possible implementation, the busbar ribbon is located on the solar cell, and each fixed point is fixedly connected to a corresponding position of the solar cells through the interconnectors thereunder.

In the above implementation process, the busbar ribbon is located on the solar cell and is fixedly connected to the interconnector, which is also located on the solar cell, thus ensuring a good fixed connection performance between the busbar ribbon and the interconnector.

In one possible implementation, each fixed point is fixedly connected to one interconnector thereunder.

In the above implementation process, each fixed point is connected to one interconnector, thereby facilitating the fixed connection between the busbar ribbon and the interconnector.

In one possible implementation, a number of interconnectors below the non-fixed sections laid on the interconnectors is 1-3.

In the above implementation process, the number of fixed points can be controlled to ensure the good fixed connection performance between the busbar ribbon and all interconnectors.

In one possible implementation, the non-fixed sections laid on the interconnectors are in contact with all the interconnectors thereunder.

In the above implementation process, the non-fixed sections of the busbar ribbon have a good connection performance with the interconnectors and are less prone to be fragmentated during lamination.

In one possible implementation, at least some of the non-fixed sections, located between adjacent interconnectors, are recessed toward the solar cells.

In the above implementation process, the recessed positions of the non-fixed sections of the busbar ribbon serve as reserved free segments, which can release stress generated by thermal expansion and contraction (e.g., during the soldering of the busbar ribbon to the interconnectors) of the busbar ribbon, thus preventing pulling offsets due to the busbar ribbon shrinkage. Therefore, the busbar is not easily broken and does not affect the lamination process.

In one possible implementation, a part of the non-fixed section in contact with the interconnectors has folded section, and the folded section does not exceed a surface of the busbar ribbon.

In the above implementation process, the folded sections of the non-fixed sections of the busbar ribbon serve as free segments, so that the entire busbar ribbon is not easy to break and does not affect the lamination process.

In one possible implementation, a material of the busbar ribbon is a tin-coated copper ribbon; a thickness of the busbar ribbon is 0.05~0.15mm; and a width of the busbar ribbon is 5~15mm.

A material of the interconnector is a tin-coated copper ribbon, and a diameter of the interconnectors is 0.15~0.3mm.

In the above implementation process, the fixed points can be directly welded to the interconnectors, which ensures the melting and contact soldering effect of the tin layer and also improves the contact effect between the non-fixed sections and the busbar ribbon.

In a fourth aspect, the embodiment of the present invention provides a photovoltaic cell module comprising a plurality of solar cell strings as described in the third aspect. The busbar ribbons of all the solar cell strings are connected in sequence.

### BRIEF DESCRIPTION OF DRAWINGS

In order to more clearly illustrate the technical solutions of the embodiments of the present invention, the following will briefly introduce the drawings used in the embodiments of the present invention. It should be understood that the following drawings only show some embodiments of the present invention, and therefore it should not be regarded as a limitation on the scope. Those ordinary skilled in the art can also obtain other related drawings based on these drawings without inventive effort.
FIG. 1 is a schematic diagram of soldering of a chamfered busbar ribbon and an interconnector provided in the first embodiment;
FIG. 2 is a schematic diagram of soldering of a rounded busbar ribbon and an interconnector provided in the first embodiment;
FIG. 3 is a schematic diagram of a structure of a solar cell string provided in the first embodiment;
FIG. 4 is a schematic diagram of a circuit of a photovoltaic cell module provided in the second embodiment;
FIG. 5 is a schematic diagram of a structure of a solar cell string provided in the third embodiment;
FIG. 6 is a schematic diagram of a middle structure of FIG. 5;
FIG. 7 is a schematic structure diagram of a solar cell with busbar ribbons provided in FIG. 6;
FIG. 8 is a schematic structure diagram from another perspective of FIG. 7;
FIG. 9 is a schematic structure diagram of a solar cell with busbar ribbons provided in a solar cell string provided in the fourth embodiment;
FIG. 10 is a schematic structure diagram of a solar cell with busbar ribbons provided in a solar cell string provided in the fifth embodiment; and
FIG. 11 is a schematic structure diagram of a structure of a photovoltaic cell module provided in the sixth embodiment.

Reference numerals: 1 - solar cell string; 2 - busbar ribbon; 3 - interconnector; 4 - solar cell; 5 - soldering part; 6 - non-soldering part; 7 - chamfer; 8 - rounded corner; 9 - bypass diode;

100 - cell string; 110 - solar cell; 120 - interconnector; 130 - busbar ribbon; 131 - fixed point; 132 - first non-fixed section; 133 - second non-fixed section.

### DETAILED DESCRIPTION OF EMBODIMENTS

The technical solutions in the embodiments of the present invention will be described below with reference to the drawings in the embodiments of the present invention.

In order to make the objective, technical solutions, and advantages of the embodiments of the present invention clearer, the following description will provide a clear and comprehensive explanation of the technical solutions in the embodiments of the present invention with reference to the drawings of the present invention. Clearly, the described embodiments are part of the embodiments of the present invention and not the entire embodiments. The components of embodiments of the present invention which are generally described and illustrated in the drawings herein can be arranged and designed in a variety of different configurations.

Accordingly, the following detailed description of the embodiments of the present invention provided in the drawings is not intended to limit the scope of the present invention for which protection is claimed, but merely represents selected embodiments of the present invention. Based on the embodiments in the present invention, all other embodiments obtained by those of ordinary skill in the art without making inventive efforts are within the scope of protection of the present invention.

It should be noted that similar numerals and letters denote similar terms in the following drawings, so that once an item is defined in one drawing, it does not need to be further discussed in subsequent drawings.

In the description of the present invention, it should be noted that the orientation or position relationships indicated by the terms "up", "down", "inside", "outside", etc., are the orientation or position relationships shown based on the drawings or the orientation or position relationships customarily placed in the use of the product of the present invention. It is only for the convenience of describing the present invention and simplifying its description and does not indicate or imply that the device or element referred to must be in a specific orientation or be constructed and operated in a specific orientation, and thus should not be construed as limiting the present invention. In addition, the terms "first", "second", and "third" are only used to distinguish the descriptive and are not to be construed as indicating or implying relative importance.

In the description of the present invention, it is further important to note that unless otherwise clearly stipulated and limited, the terms "provide", "mount", and "connect" should be understood in a broad sense, for example, it can be a fixed connection, a detachable connection, or an integral connection; it can be a mechanical connection, or an electrical connection; and it can be a direct connection, an indirect connection through an intermediary, or an internal communication between two components. Those of ordinary skill in the art can understand the meanings of the above terms in the present invention according to specific situations.

### First embodiment

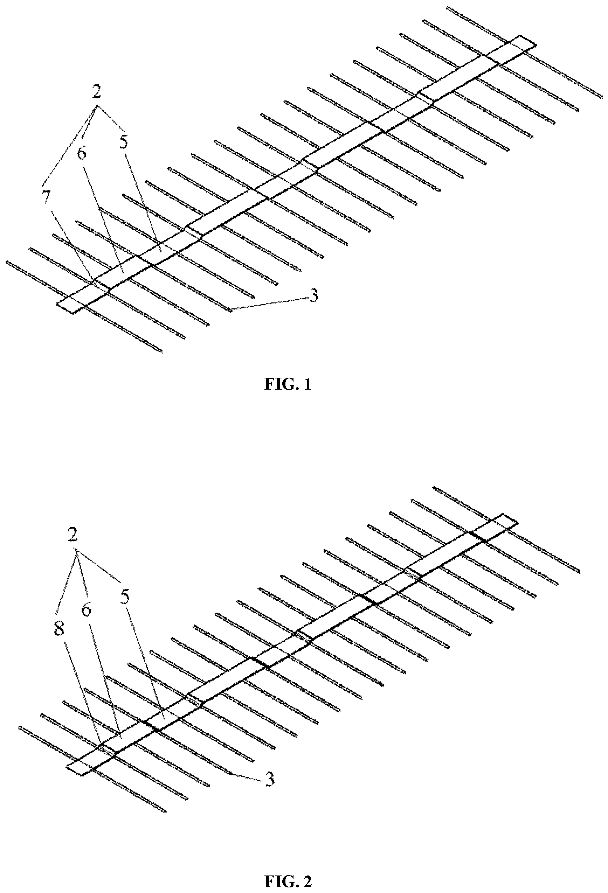

Referring to FIG. 1 to FIG. 4, the embodiments of the present invention provide a solar cell string 1, including busbar ribbons 2, interconnectors 3, and solar cells 4. A plurality of solar cells 4 are arranged sequentially along a preset direction, and adjacent solar cells 4 are connected through the interconnector 3. The busbar ribbon 2 is provided on the solar cell 4 and extends along an arrangement direction of the solar cell 4. Along the extension direction of the busbar ribbon 2, the busbar ribbon 2 comprises a plurality of soldering parts 5 and non-soldering parts 6 connecting two adjacent soldering parts 5, wherein the soldering parts 5 are welded with at least one interconnector 3, and the non-soldering parts 6 are arranged with spacing from at least one interconnector 3.

In the embodiment, the busbar ribbon 2 is arranged on the solar cell 4 and directly welded to the interconnector 3 through soldering parts 5, thus ensuring the melting and contact soldering effect of the tin layer. The non-soldering parts 6 are arranged with spacing from at least one interconnector 3, which can release the stress generated by thermal expansion and contraction between the busbar ribbon 2 and the interconnector 3 during the soldering process of the busbar ribbon, preventing pulling and misalignment of the soldering tape on the rear surface of the solar cell 4 caused by shrinkage after soldering of the busbar ribbon 2. Compared to the direct contact soldering of the busbar ribbon 2 and the solder pad on the rear surface of the solar cell 4 in prior traditional shingled photovoltaic cell modules, this arrangement has a lower fragmentation rate, a larger process window, and does not require auxiliary soldering materials such as solder paste or flux. Additionally, the amount of back silver is significantly reduced, thus improving the solar cell efficiency. Even for thinner solar cells 4, the risk of micro cracks in the solar cell 4 is lower. Compared to the soldering method of prior half-cell modules, this arrangement eliminates the need for a 10mm~20mm soldering region between the busbar ribbon 2 and the interconnector 3 in the middle of the module. During soldering, the head and tail cell strings of the module do not need to be misaligned, and the soldering of interconnectors 3 on both sides does not interfere with each other, thereby improving module efficiency. Furthermore, it releases the pulling force exerted on the cell strings by encapsulant flow during the lamination process, thus reducing the risk of micro cracks and fragmentation in the cell strings, and enhancing the overall aesthetic appearance.

In the embodiment, the busbar ribbon 2 and the interconnector 3 connected to the solar cell 4 are directly welded, instead of the traditional shingled photovoltaic cell module where the busbar ribbon 2 and the solder pad on the rear surface of the solar cell 4 are directly contact-welded. This can solve problems of the process defects caused by soldering the PAD on the rear surface of the solar cell 4 and the busbar ribbon 2 in the traditional shingled photovoltaic cell module, such as an increase of 0.02% to 0.05% in the fragmentation rate, a narrow process window, and the need to add auxiliary soldering materials such as solder paste or flux. At the same time, it can reduce the impacts such as the soldering effect, module efficiency, and post-lamination appearance, which are caused by the 10~20mm soldering region between the busbar ribbon 2 and interconnector 3. It can release the pulling force exerted on the cell strings by encapsulant flow during the lamination process, thus preventing micro cracks in the cell string.

In the optional technical solution of the embodiment, the non-soldering parts 6 are arched relative to two adjacent soldering parts 5.

In the embodiment, along the extension direction of the busbar ribbon 2, the soldering part 5 is planar, and the non-soldering part 6 is arched, so that the soldering part 5 can be welded with the interconnector 3, and the non-soldering part 6 can span the interconnector 3. The structure is simple and easy to manufacture.

The embodiment is not limited to this. The soldering part 5 and the non-soldering part 6 can both be planar, with the thickness of the soldering part 5 greater than the thickness of the non-soldering part 6. That is, the soldering part 5 can contact and weld with the interconnector 3, and a gap is arranged between the non-soldering part 6 and the interconnector 3.

In the optional technical solution of the embodiment, an arched shape of the non-soldering parts 6 is arc-shaped, triangular, trapezoidal, or rectangular. However, the non-soldering part 6 can also be of any other shape that meets the requirements.

Preferably, the busbar ribbon 2 is of an integrally formed structure, which is stable in structure and easy to manufacture. The soldering part 5 is planar to ensure the melting and contact soldering effect of the tin layer, and the arched non-soldering part 6 can release the stress generated by thermal expansion and contraction between the busbar ribbon 2 and the interconnector 3 during the soldering process of the busbar ribbon 2, preventing pulling and misalignment of the soldering tape on the rear surface of the solar cell 4 caused by shrinkage after soldering of the busbar ribbon 2.

In the optional technical solution of the embodiment, a joint between the soldering part 5 and the non-soldering parts 6 is arranged as a chamfer 7, a right angle, or a rounded corner 8.

In the embodiment, the arched transition between the soldering part 5 and the non-soldering part 6 is a chamfer 7, a right angle, or a rounded corner 8, so that the overall arching of the busbar ribbon 2 forms the non-soldering part 6 better.

In the optional technical solution of the embodiment, an arching height of the non-soldering parts 6 is h, and 0 < h ≤ 2mm. The structure is simple and easy to manufacture, without occupying excessive space.

Specifically, based on the number of main grids on different solar cells 4 and the number of soldering points, that is, the soldering locations between the soldering part 5 and the interconnector 3, the optimal design for the number, height, and shape of arches based on the busbar ribbon 2 is carried out. The soldering part 5 of the busbar ribbon 2 and the interconnector 3 on the rear surface of the solar cell 4 are designed to be in contact, and the non-soldering part 6 is designed with arching. Preferably, the number of arches ranges from 2 to 19, but the specific number depends on the requirements.

In the optional technical solution of the embodiment, the solar cells 4 have a front surface and a rear surface, and the busbar ribbon 2 is located on the rear surface of the solar cells 4 and welded with the rear surface of the interconnector 3. This does not affect usage on the front surface.

In the optional technical solution of the embodiment, a thickness of the busbar ribbon 2 is 0.05mm-0.15mm.

In the optional technical solution of the embodiment, a width of the busbar ribbon 2 is 5mm-15mm.

In the embodiment, the busbar ribbon 2 is designed to be thinner and wider, which can solve the issue of micro cracks during soldering of the solar cell 4 and improve the current-carrying capacity of the solar cell.

In an optional technical solution of the embodiment, the solar cell 4 is formed by cutting a 182-millimeter silicon wafer into two or three slices, or the solar cell 4 is formed by cutting a 210-millimeter silicon wafer into two or three slices.

In the embodiment, the solar cell 4 uses large-size silicon wafers such as 182/210 (mm), designed to be cut into two or three slices, with 10 to 20 BB designs for the main grid lines, compatible with process solar cells such as Perc, N-type, and HJT.

### Second embodiment

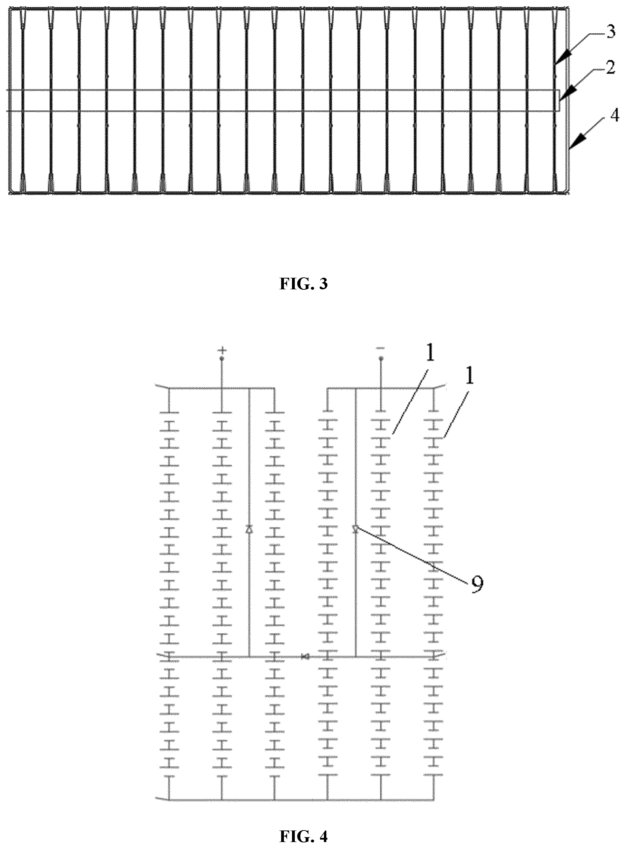

In conjunction with FIG. 4, the photovoltaic cell module provided in the embodiment includes the aforementioned solar cell string 1. Accordingly, the technical advantages and effects achieved by the photovoltaic cell module include the technical advantages and effects achieved by the aforementioned solar cell string 1, which are not elaborated herein.

Specifically, the photovoltaic cell module includes three bypass diodes 9 and six solar cell strings 1 arrayed parallelly.

The six solar cell strings 1 comprises three solar cell strings 1 on a left side connected in parallel to form a first group, and three solar cell strings 1 on a right side connected in parallel to form a second group, wherein the first group and the second group are connected in series.

The three bypass diodes 9 are connected in parallel through the busbar ribbon 2.

In the embodiment, the photovoltaic cell module adopts a six-string module design, with the circuit configured as three solar cell strings 1 on the left side connected in parallel and three solar cell strings 1 on the right side connected in parallel. The three solar cell strings 1 on each side are then connected in series. Additionally, by optimizing the connection between the interconnector 3 on the rear surface of the solar cell 4 and the corresponding busbar ribbon 2 of the bypass diode 9, the electrical connection design of three bypass diodes 9 in parallel is achieved. The structure is simple, and the conductivity efficiency is high.

### Third embodiment

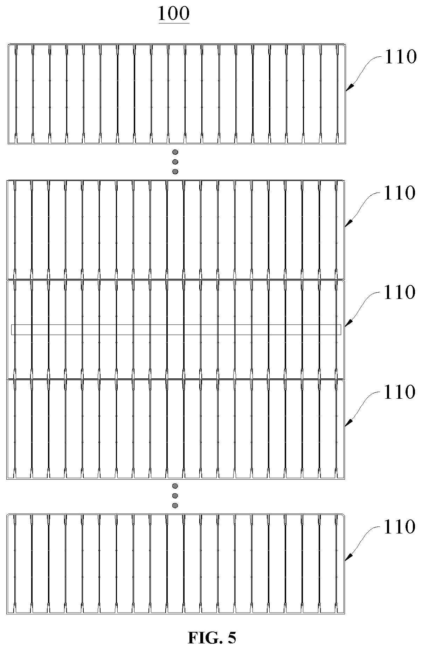

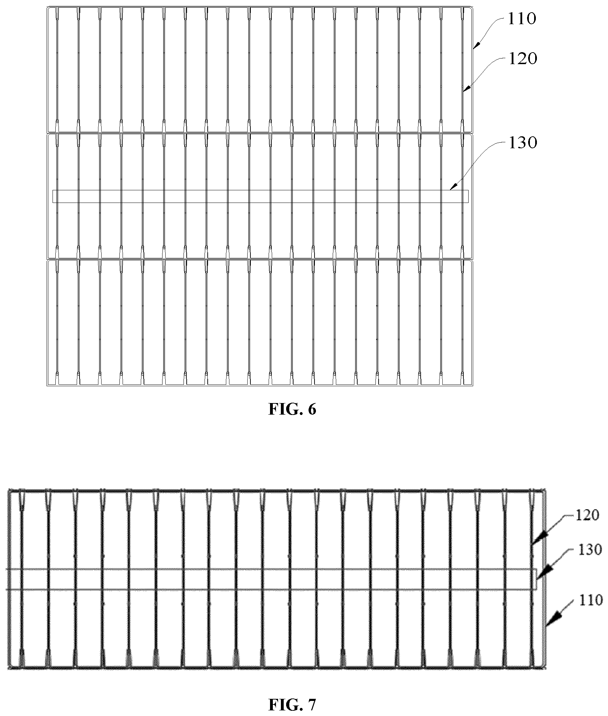

Referring to FIG. 5, FIG. 6, FIG. 7, and FIG. 8, the embodiment provides a solar cell string 100, including at least two solar cells 110 arranged sequentially, wherein two adjacent solar cells 110 are respectively connected through a plurality of interconnectors 120, and one busbar ribbon 130 is provided on all the interconnectors 120 connected to at least one solar cell 110. The busbar ribbon 130 comprises a plurality of fixed points 131 arranged at intervals along a length direction and non-fixed sections connecting two adjacent fixed points 131; the fixed points 131 are fixedly connected to the interconnectors 120 thereunder; at least some of the non-fixed sections are laid on the interconnectors 120, the non-fixed sections are not fixedly connected to the interconnectors 120 thereunder; and the non-fixed sections are in contact with at least a partial number of the interconnectors 120 thereunder.

In the embodiment of the present invention, the busbar ribbon 130 in the solar cell string 100 is arranged as follows: a busbar ribbon 130 is arranged on the interconnectors 120 of a certain solar cell. Typically, one busbar 130 is arranged for the solar cell string 100, but two or more busbar ribbons 130 can also be arranged as needed. The solar cell 110 has a front surface and a rear surface, where the front surface and the rear surface refer to the two opposite surfaces of the solar cell 110. The front surface is the surface facing the sun during actual use, and the rear surface is the surface facing away from the sun. In one embodiment, the connection between two adjacent solar cells 110 via the interconnector 120 refers to the front surface (positive electrode) of one solar cell 110 being connected to the rear surface (negative electrode) of an adjacent solar cell 110 through the interconnector 120. The solar cell string 100 is connected such that the front surface of the first solar cell 110 is connected to the rear surface of the second solar cell 110 via the interconnector 120, and the front surface of the second solar cell 110 is connected to the rear surface of the third solar cell 110 via the interconnector 120. In one embodiment, the busbar ribbon 130 is located on the rear surface of the middle solar cell 110 and is welded to the rear surface of the interconnector 120 located on the backside. FIGS. 5, 6, and 7 show the connection on the rear surface of the solar cell 110, where the dots in FIG. 5 represent solar cells not illustrated.

In the embodiment of the present invention, the fixed point 131 of the busbar ribbon 130 refers to the position where the busbar ribbon 130 is fixed to the corresponding interconnector 120 through a securing method. The fixed point 131 and the interconnector 120 do not separate during conventional processing or use. The non-fixed sections of the busbar ribbon 130 are divided into two types. One type is a first non-fixed section 132, under which an interconnector 120 (that is laid on the interconnection bar 120) is provided, where this non-fixed section is not fixed by any fixing method or not fixed by soldering. The non-fixed section and the corresponding interconnector 120 can be separated. Another type is a second non-fixed section, which is not provided with an interconnector 120 underneath. These non-fixed sections will not necessarily be connected to or in contact with the interconnector 120.

Exemplarily, the fixing methods include soldering and bonding. Soldering includes mainstream soldering methods, such as infrared heating, electromagnetic heating, or hot air soldering, which weld the busbar ribbon 130 and the interconnector 120 together. Bonding includes using electrically conductive adhesives, such as conductive glue, insulating glue, thermosetting glue, or UV glue, where different electrically conductive adhesives have different curing conditions. Conductive glue, insulating glue, and thermosetting glue require heating or lamination processes for curing, and UV glue requires ultraviolet light exposure or heating for curing.

The non-fixed section does not need to be fixed or can be fixed by using a low-temperature busbar ribbon 130 or a low-temperature interconnector 120 with a lower melting point (e.g., SnPbBi or SnBiAg alloys). During the lamination process, the materials are melted and solidified, forming a good physical contact between the busbar ribbon 130 and the interconnector 120 after lamination.

In some embodiments of the present invention, the solar cell 100 can be formed by dividing a 182mm silicon wafer into two or three slices; or in some other embodiments of the present invention, the solar cell 100 can further be formed by dividing a 210mm silicon wafer into two or three slices.

In some embodiments of the present invention, the solar cells 110 are arranged in parallel along the arrangement direction (without overlapping), and the solar cells are electrically connected via the interconnectors 120.

In some embodiments of the present invention, the material of the busbar ribbon 130 is a tin-coated copper ribbon or another conductive material, wherein a thickness of the busbar ribbon is 0.05~0.15mm, and a width of the busbar ribbon is 5~15mm.

The material of the interconnector 120 is a tin-coated copper ribbon or another conductive material, and a diameter of the interconnectors is 0.15~0.3mm.

In some embodiments of the present invention, the busbar ribbon 130 is located on the solar cell, and each fixed point 131 is fixedly connected to the solar cells 110 at a corresponding position through the interconnectors 120 thereunder. The number of fixed points 131 is typically 4 to 20, ensuring the current-carrying capacity and connection strength of the busbar ribbon 130 and the interconnector 120. In some embodiments of the present invention, a number of interconnectors 120 below the non-fixed sections laid on the interconnectors 120 is 1-3.

In the embodiment, each fixed point 131 is fixedly connected to one interconnector 120 below it via soldering. Specifically, it is connected by soldering. The interconnector 120 corresponding to the fixed point 131 is discontinuously arranged, without a second non-fixed section. Each non-fixed section (the first non-fixed section 132) laid on the interconnector 120 is provided with two interconnectors 120 below it. Each non-fixed section (the first non-fixed section 132) laid on the interconnector 120 is in contact with all interconnectors 120 below it. From the overall point of view, the busbar ribbon 130 is entirely in a flat state, with the fixed points 131 of the busbar ribbon 130 fixedly connected to the interconnectors 120. The non-fixed sections are in contact with the interconnectors 120. In other embodiments, the number of interconnectors 120 below each non-fixed section (the first non-fixed section 132) can be three or more. In other embodiments, each non-fixed section (the first non-fixed section 132) contacts some of the interconnectors 120 below it but does not contact other interconnectors 120, such as being spaced a distance from the interconnectors 120. In other embodiments, the busbar ribbon 130 can also have a curved form on the surface of the solar cell, which can similarly reduce stress on the busbar ribbon 130.

### Fourth embodiment

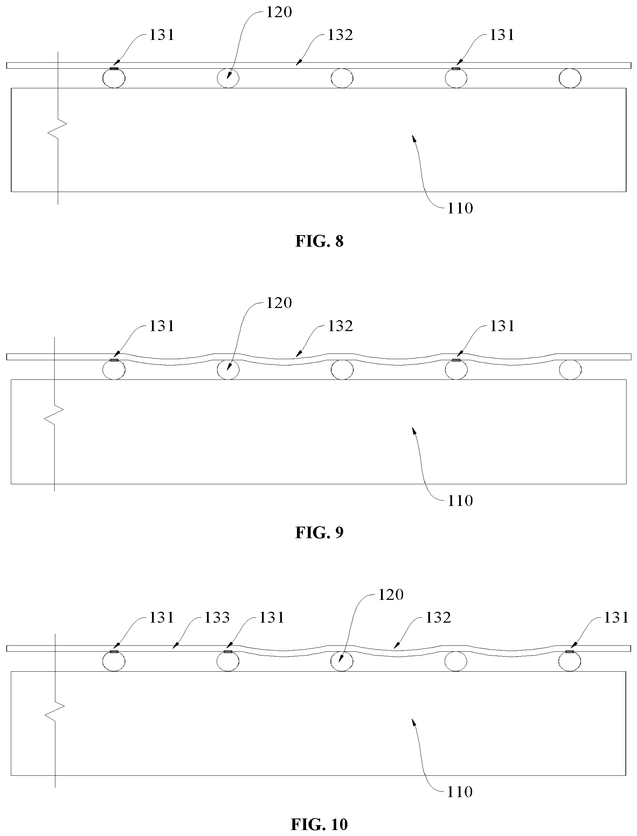

Referring to FIG. 9, the solar cell string provided in the embodiment differs from the third embodiment in that: at least some of the non-fixed sections, located between adjacent interconnectors, are recessed toward the solar cells 110, and the joints between the recessed positions and other positions are arranged as chamfers, right angles, or rounded corners. In the embodiment, each non-fixed section (the first non-fixed section 132) located between adjacent interconnectors 120 is recessed toward the direction of the solar cell 110.

In other embodiments, the busbar ribbon 130 with extra length can be folded during lamination. Specifically, the part of the non-fixed section in contact with the interconnector 120 can be provided with folded section, and the height of the folded section does not exceed the surface of the busbar ribbon 130.

### Fifth embodiment

Referring to FIG. 10, the solar cell string provided in the embodiment differs from the third embodiment in that: some of the adjacent interconnectors 120 are respectively provided with fixed points 131 in a connection method, and some of the adjacent interconnectors 120 are provided with non-fixed sections laid thereon, wherein the non-fixed sections are in contact with the interconnectors 120 beneath them. In the embodiment, the busbar ribbon 130 is fixed together with two consecutive interconnectors 120, forming two fixed points 131. The non-fixed section between the two fixed points 131 is the second non-fixed section 133, which is in a flat state. The busbar ribbon 130 is then laid on two consecutive interconnectors 120 to form a repeating unit. Subsequent busbar ribbons 130 are arranged based on the repeating unit. The non-fixed section laid on the interconnector 120 is the first non-fixed section 132, with two interconnectors 120 beneath it. The part of the non-fixed section between adjacent interconnectors 120 is recessed toward the direction of the solar cell 110.

### Sixth embodiment

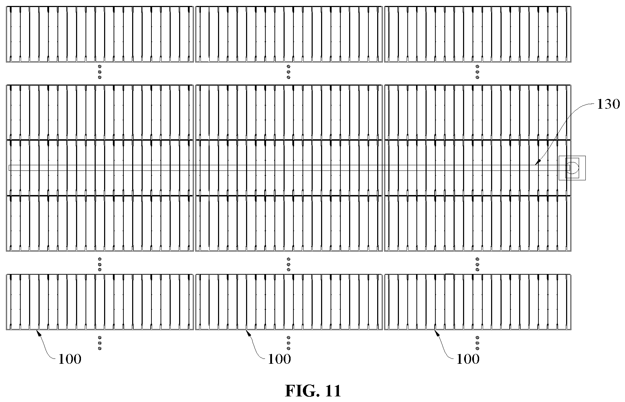

Referring to FIG. 11, the embodiment provides a photovoltaic cell module that includes multiple solar cell strings from the third embodiment, wherein the solar cell strings are arrayed parallelly. The busbar ribbons 130 of the solar cell strings are sequentially connected, and the non-fixed section of the busbar ribbons 130 refers to the region where no soldering or fixation has been performed. In FIG. 11, the dots represent solar cells that are not shown. In the embodiment, the same busbar ribbon 130 connects all the solar cell strings. In other embodiments, the busbar ribbon 130 of each solar cell string can be independently arranged and then connected together.

In summary, the solar cell string and photovoltaic cell module provided by the embodiments of the present invention eliminate the need for the arrangement of solder pads on the surface and additional auxiliary soldering materials, thereby reducing the material consumption of a single solar cell and improving solar cell efficiency. This ensures a good connection performance of the busbar ribbon, reduces the occurrence of defects, prevents pulling and twisting caused by slight displacement of the cell string, and improves the overall aesthetic appearance of the module.

The above is only an embodiment of the present invention, which is not intended to limit the scope of protection of the present invention, and the present invention can have various changes and variations for those skilled in the art. Any modification, equivalent substitution, improvement, etc. made within the spirit and principles of the present invention shall be included in the scope of protection of the present invention.

### Industrial practicality

The present invention provides a solar cell string and a photovoltaic cell module in which the busbar ribbon is connected to the interconnectors through soldering parts or fixed points. A gap is provided between the non-soldering part of the busbar ribbon and the interconnector, or the non-fixed section is in contact with the interconnector. This not only ensures the connection effect, but also prevents pulling and twisting phenomena, thus having industrial practicality.

## Claims

1. A solar cell string, comprising: busbar ribbons, interconnectors, and solar cells;
a plurality of solar cells are arranged sequentially along a preset direction, and the adjacent solar cells are connected through the interconnectors;
the busbar ribbons are provided on the solar cells and extend along an arrangement direction of the solar cells; and
along the extension direction of the busbar ribbons, the busbar ribbons comprise a plurality of soldering parts and non-soldering parts connecting the two adjacent soldering parts, wherein the soldering parts are welded with at least one of the interconnectors, and the non-soldering parts are arranged with spacing from at least one of the interconnectors.

2. The solar cell string according to claim 1, wherein the non-soldering parts are arched relative to the two adjacent soldering parts.

3. The solar cell string according to claim 2, wherein an arched shape of the non-soldering parts is arc-shaped, triangular, trapezoidal, or rectangular.

4. The solar cell string according to claim 2 or 3, wherein a joint between the soldering parts and the non-soldering parts is arranged as chamfered, right-angled, or rounded.

5. The solar cell string according to any one of claims 2 to 4, wherein an arching height of the non-soldering parts is h, and 0 < h ≤ 2mm.

6. The solar cell string according to any one of claims 1 to 5, wherein the solar cells have a front surface and a rear surface, and the busbar ribbons are located on the rear surface of the solar cells and welded with the rear surface of the interconnectors.

7. The solar cell string according to any one of claims 1 to 6, wherein a thickness of the busbar ribbons is 0.05mm-0.15mm.

8. The solar cell string according to any one of claims 1 to 7, wherein a width of the busbar ribbons is 5mm-15mm.

9. The solar cell string according to any one of claims 1 to 8, wherein the solar cells are formed by dividing a 182mm silicon wafer into two or three slices; or
the solar cells are formed by dividing a 210mm silicon wafer into two or three slices.

10. A photovoltaic cell module, comprising three bypass diodes and six solar cell strings according to any one of claims 1-9 arrayed parallelly;
the six solar cell strings comprise three solar cell strings on a left side connected in parallel to form a first group, and three solar cell strings on a right side connected in parallel to form a second group, wherein the first group and the second group are connected in series; and
the three bypass diodes are connected in parallel through the busbar ribbons.

11. A solar cell string, comprising: at least two solar cells arranged sequentially, wherein two adjacent solar cells are respectively connected therebetween through a plurality of interconnectors, and one of the busbar ribbons is provided on all the interconnectors connected to at least one of the solar cells; and
the busbar ribbons comprise a plurality of fixed points arranged at intervals along a length direction and non-fixed sections connecting the two adjacent fixed points, wherein the fixed points are fixedly connected to the interconnectors thereunder; at least some of the non-fixed sections are laid on the interconnectors; the non-fixed sections are not fixedly connected to the interconnectors thereunder; and the non-fixed sections are in contact with at least some of the interconnectors thereunder.

12. The solar cell string according to claim 11, wherein the busbar ribbons are located on the solar cell, and each of the fixed points is fixedly connected to a corresponding position of the solar cells through the interconnectors thereunder.

13. The solar cell string according to claim 11 or 12, wherein each of the fixed point is fixedly connected to one of the interconnectors thereunder.

14. The solar cell string according to any one of claims 11 to 13, wherein a number of interconnectors below the non-fixed sections laid on the interconnectors is 1-3.

15. The solar cell string according to any one of claims 11 to 14, wherein the non-fixed sections laid on the interconnectors are in contact with all the interconnectors thereunder.

16. The solar cell string according to any one of claims 11 to 15, wherein at least some of the non-fixed sections, located between the adjacent interconnectors, are recessed toward the solar cells.

17. The solar cell string according to any one of claims 11 to 16, wherein a part of the non-fixed section in contact with the interconnector has a folded section, and the folded section does not exceed a surface of the busbar ribbons.

18. The solar cell string according to any one of claims 11 to 17, wherein a material of the busbar ribbons is a tin-coated copper ribbon; a thickness of the busbar ribbons is 0.05~0.15mm; and a width of the busbar ribbons is 5~15mm.

19. The solar cell string according to any one of claims 11 to 18, wherein a material of the interconnectors is a tin-coated copper ribbon, and a diameter of the interconnectors is 0.15~0.3mm.

20. A photovoltaic cell module, comprising a plurality of solar cell strings according to any one of claims 11-19, wherein the busbar ribbons of all the solar cell strings are connected sequentially.
